# EUROPÄISCHE PATENTSCHRIFT

(11) **EP 3 520 581 B1**
(45) Veröffentlichungstag und Bekanntmachung des Hinweises auf die Patenterteilung: **08.05.2024**
(21) Anmeldenummer: 17791925.5
(22) Anmeldetag: 26.09.2017
(51) Int. Cl.: H05K 3/30, H01R 4/02, H01R 12/71, H01R 43/02

(54) **BAUELEMENT, POSITIONIERVORRICHTUNG UND VERFAHREN ZUR LÖTBEFESTIGUNG DES BAUELEMENTS**
COMPONENT, POSITIONING DEVICE AND METHOD FOR FASTENING THE COMPONENT BY SOLDERING
COMPOSANT, DISPOSITIF DE POSITIONNEMENT ET PROCÉDÉ DE FIXATION DE SOUDURE DU COMPOSANT

(30) Priorität: 29.09.2016 DE 102016118527
(43) Veröffentlichungstag der Anmeldung: 07.08.2019
(73) Patentinhaber: PHOENIX CONTACT GmbH & Co. KG, 32825 Blomberg Nordrhein-Westfalen (DE)
(72) Erfinder: SAHM, Jürgen, 72119 Ammerbuch (DE); ROSEMEYER, Ulrich, 32816 Schieder Schwalenberg (DE)
(86) Internationale Anmeldenummer: PCT/DE2017/100822
(87) Internationale Veröffentlichungsnummer: WO 2018/059625

(56) Entgegenhaltungen:
- EP-A1- 1 881 565
- WO-A1-97/17823
- DE-A1- 4 309 511
- GB-A- 2 390 493
- JP-A- H06 283 222
- US-A1- 2006 068 618
- US-A1- 2010 165 590

## Beschreibung

Die Erfindung betrifft ein Verfahren zur Lötbefestigung eines Bauelements auf der Leiterplatte. Dabei bezieht sich die Erfindung insbesondere auf die Montage von Bauelementen auf Leiterplatten und deren Positionierung vor dem Verlöten mit der Leiterplatte.

Aus der DE 10 2008 029 123 A1 ist eine Anordnung und ein Verfahren zur Lötbefestigung eines Bauelements auf einer Leiterplatte ist bekannt. Dabei weist eine in einem Stück gefertigte Halterung ein Montageelement sowie daran befestigte Abstandshalter auf, die der Fixierung der Halterung auf der Leiterplatte dienen. Durch die flexibel gestaltete Aufhängung der Abstandshalter an dem Montageelement befinden sich im vormontierten Zustand die Abstandshalter in der durch das Montageelement definierten Ebene, wobei die Abstandshalter zur Montage der Halterung auf der Leiterplatte abgewinkelt werden.

Weiterhin ist aus DE 100 21 396 A1 eine Vorrichtung zur Halterung eines Moduls auf einer Leiterplatte bekannt, welche ein aus der Ebene der Leiterplatte herausragendes und an der Leiterplatte angebrachtes Halteelement und ein Adapterelement aufweist, das eine Ausnehmung zur Aufnahme des Moduls besitzt, wobei das Halteelement so ausgebildet ist, dass das Adapterelement in horizontaler Richtung in das Halteelement einführbar ist und nach einer Kopplung mit dem Halteelement von diesem weitgehend umfasst wird.

US 2006/068618 A1 offenbart eine Anordnung und ein Verfahren zur Lötbefestigung eines Bauelements.

Bei den die Erfindung betreffenden Bauelementen handelt es sich beispielsweise um elektrische Steckverbinder oder andere elektrische/elektromechanische Bauelemente, die auf einer Leiterplatte zu befestigen sind und hierzu zumindest elektrische Anschlusselemente, die üblicherweise in entsprechende Bohrungen der Leiterplatte eingeführt und mit dieser verlötet werden, aufweisen. Es ist bekannt, elektrische Bauelemente, die nach dem Aufsetzen auf der Leiterplatte aufgrund ihres Schwerpunktes ihre Position verändern, oder Bauelemente, die auf Grund ihrer Größe oder mechanischen Einwirkungen nach dem Verlöten, wie beispielsweise Anschließen eines Steckverbinders ihre Position verändern, zur Stabilisierung mit zusätzlichen Rasthaken zu Befestigung auf der Leiterplatte auszulegen. Diese sind für industrielle Lötprozesse im Wesentlichen nur für Wellenlötprozesse wirtschaftlich geeignet, da bei der Bestückung der Leiterplatte mit den elektronischen/elektromechanischen Bauelementen große Kräfte wirken, um die Rasthaken der Bauelemente auszulenken und in den Fangbohrungen der Leiterplatte einrasten zu lassen. Durch die Erschütterungen, die bei der Fixierung der Rasthaken auf die Leiterplatte wirken, können weiterhin auch andere auf der Oberfläche montierte Bauelemente (SMD-BE) aus ihrer Bestückposition verschoben werden. Für eine automatisierte Bestückung sind die bekannten Lösungen daher nicht geeignet. Jedoch entsteht zunehmend die Anforderung derartig bestückte Leiterplatten vornehmlich auch im Reflow-Prozess zu verlöten.

Der Erfindung liegt die Aufgabe zugrunde, den vorstehend genannten Stand der Technik zu verbessern und Möglichkeiten vorzuschlagen, die eine Bestückung der Leiterplatte mit elektronischen/elektromechanischen Bauelementen, die entweder nach dem Verlöten noch mechanische Kräfte aufnehmen und/oder bei der Bestückung in einer stabilen Lage gehalten werden müssen, erlauben.

Diese Aufgabe wird erfindungsgemäß durch ein Verfahren mit den Merkmalen des Anspruchs 1 gelöst. Weitere vorteilhafte Ausgestaltungen sind den jeweils rückbezogenen Patentansprüchen zu entnehmen.

Ein Beispiel für ein Bauelement, das nicht Teil der Erfindung ist, weist eine Positioniervorrichtung auf, die mindestens eine Stütze zur lösbaren Abstützung der Positioniervorrichtung auf der Leiterplatte und mindestens ein lösbar mit dem Bauelement verbindbares Halteelement aufweist, das bei der Montage des Bauelements auf einer Leiterplatte das Bauelement haltend anordenbar ist. Die Positioniervorrichtung besteht somit aus einem Halteelement, das so ausgestaltet ist, dass es lösbar mit dem Bauelement in Verbindung gebracht werden kann, um bei der Montage des Bauelements auf der Leiterplatte dieses in geeigneter Weise zu unterstützen, damit es in seiner Position gehalten wird bis das Verlöten erfolgt. Dies tritt insbesondere bei kopflastigen Bauelementen auf, also Bauelementen, die einen Schwerpunkt aufweisen, der nach der Positionierung zum Kippen des Bauelements führt und damit auch die elektrischen Anschlüsse in den Kontaktbohrungen der Leiterplatte verändern. Die Unterstützung durch das Halteelement kann entsprechend der Ausgestaltung des Bauelements und dem jeweiligen Anwendungsfall erfolgen. Das Halteelement kann daher so ausgebildet sein, dass es entsprechend dem zu unterstützenden Bauelement, das beispielsweise einen Steckverbinder aufweist, einen Eingriff in den Steckverbinder, zum Beispiel in die Buchse, oder entsprechende Öffnungen für die Steckerstifte aufweist. Genauso ist es möglich, dass das Halteelement das Bauelement mit oder ohne Steckverbinder stirnseitig umgreift, untergreift oder in einer sonst geeigneten Weise zur Unterstützung dient. Das Bauelement kann zusätzlich weitere Abstützelemente aufweisen, die nicht stirnseitig sondern seitlich angebracht sind und mit denen das Halteelement der Positioniervorrichtung in Eingriff gelangen kann. Neben dem Halteelement weist die Positioniervorrichtung eine Stütze zur lösbaren Abstützung der Positioniervorrichtung auf der Leiterplatte auf. Die Position der Positioniervorrichtung wird über die Stütze durch die Auflage auf der Leiterplatte mittels der in Lotrichtung zur Oberfläche der Leiterplatte wirkenden Gewichtskraft gehalten, womit ein mit dem Halteelement der Positioniervorrichtung lösbar verbundenes Bauteil eines Bauelements nicht mehr ausgelenkt und/oder verschoben werden kann. Bei Bauelementen, die sich am Rande der Leiterplatten befinden, ist es auch möglich, dass sich die Positioniervorrichtung auf der benachbarten Leiterplatte abstützt. Die Positioniervorrichtung wird nach dem Verlöten des Bauelements mit der Leiterplatte entfernt.

In einem weiteren Beispiel weist das Bauelement zusätzlich mindestens ein nach außen gerichteten Abstützelement auf, welcher vorzugsweise lösbar mit der Bauelement verbunden ist. Derartige Abstützelemente sind bevorzugt seitlich an dem Bauelement, beispielsweise einem Steckverbinder, angeordnet. An der Rückseite des Steckverbinders befinden sich die Anschlussleitungen und an der Stirnseite ist der Gegenstecker einsteckbar. Für Bauelementen mit ungünstigem Schwerpunkt, also solche, die aufgrund ihrer bauartbedingten Gewichtsverteilung im unverlöteten Zustand nicht ohne äußere Einwirkungen die auf der Leiterplatte vorgesehene Position und Ausrichtung beibehalten können, ist die Position des mindestens einen Abstützelementes an dem Bauelement so ausgestaltet, dass das Bauelement durch das Halteelement sicher an der vorgegebenen Position gehalten werden kann. Dafür kann das mindestens eine Abstützelement an jedem Bauteil des Bauelements so ausgebildet sein, dass es entweder als Arm oder Flügel von dem Bauelement seitlich absteht oder auch in Richtung Leiterplatte abgewinkelt ist. Im ersten Fall findet die Unterstützung durch die Positioniervorrichtung statt, während im zweiten Fall die Abstützung direkt auf der Leiterplatte aufsteht. Wenn das Bauelement über die mit dem Abstützelement vorzugsweise lösbar verbundene Positioniervorrichtung geführt wird, wird diese nach dem Lötprozess wieder vom Abstützelement gelöst und entfernt. Die lösbare Befestigung des mindestens einen Abstützelementes an dem Bauelement, beispielsweise durch Abbrechen, dient entweder dessen Entfernung nach dem Lötprozess zwecks Optimierung der Bauteilgruppierung auf der begrenzten Fläche einer Leiterplatte oder auch der Entfernung dann, wenn die Abstützung ausschließlich über die Positioniervorrichtung stirnseitig erfolgt, wie beispielsweise bei einem Steckverbinder. In diesem Fall wird die Abstützung nicht benötigt.

Zweckmäßigerweise ist das Halteelement derart ausgebildet, dass es zumindest teilweise ein an dem Bauelement befindliches Kontaktelement im verbundenen Zustand umgreift und/oder in das Kontaktelement eingreift oder das mindestens eine Abstützelement zumindest teilweise umgreift. Das Bauelement selbst kann in diesem Fall auch das Kontaktelement sein. Endsprechend der Ausbildung des Kontaktelements als Buchse oder Stecker wird die Gestalt des Halteelements so ausgeformt, dass eine lösbare Verbindung durch das Zuführen des Halteelement zum Kontaktelement aus mindestens einer Bewegungsrichtung realisiert werden kann und gleichzeitig eine stabile Stützposition vorzugsweise mindestens in Richtung der Leiterplatte gewährleistet ist. Dies kann beispielsweise durch die Ausgestaltung mit entsprechenden Polbildern als Stecker oder Buchse oder einfach als ein das Bauelement untergreifendes oder ein umgreifendes Halteelement erfolgen. Die durch den Abstützelement gebotene mögliche zusätzliche Angriffsfläche erlaubt es, dass Bauelement mittels des Halteelements für den Lötprozess auf der vorgegebenen Position zu halten.

In einem weiteren Beispiel weist das Bauelement mindestens ein Fixierelement zur mechanischen Fixierung der Leiterplatte mit einem Schaft mit mindestens einem in axialer Richtung wirkenden Rastmittel auf. Das Fixierelement kann verschiedene Ausgestaltungen aufweisen, wobei wesentlich ist, dass es eine Verbreiterung, beispielsweise in Form eines Rasthakens, einer Verengung in Form einer Einschnürung in dem Schaft, einem Gewinde oder beispielsweise bei der Ausbildung in Form einer Öse eine Öffnung aufweist, in die Lot eindringen kann, so dass eine Bewegung in axialer Richtung nicht mehr möglich ist und infolgedessen das Bauelement zusätzlich auf der Leiterplatte mechanisch fixiert wird. Dies ist besonders bei größeren oder freitragenden Bauelementen wichtig, um die Lötverbindungen für die elektrischen Anschlüsse mechanisch nicht oder möglichst wenig zu belasten. Besonders vorteilhaft ist, dass das Fixierelement nicht metallisch ausgebildet sein muss und eine Fixierung in einer entsprechend großen Fangbohrung in der Leiterplatte trotzdem möglich ist. Besonders bevorzugt ist daher ein Fixierelement aus Kunststoff. Vorzugsweise ist die Fangbohrung metallisiert. In diesem Zusammenhang ist es auch von großer Bedeutung, dass das Fixierelement in die Fangbohrung kräftefrei eingesteckt werden kann, weil diese einen ausreichenden Durchmesser aufweist. Beim Aufstecken eines derartigen Bauelements besteht daher nicht mehr die Gefahr, dass bereits auf der Leiterplatte befindliche andere Bauelemente durch Erschütterung aus ihrer Position herausbewegt werden.

Das erfindungsgemäße Verfahren zur Lötbefestigung eines Bauelements sieht die in Anspruch 1 angegebenen Schritte vor.

Das Verfahren berücksichtigt die Herstellung sowohl im Wellenlöt-Prozess als auch im Reflow-Prozess. Das Merkmal Aufschmelzen und Erstarren trifft auch für die Verwendung eines Leitklebers zu.

Der, verglichen mit den üblichen Verfahrensweisen, vergrößerte Durchmesser der vorzugsweise metallisierten Fangbohrung gewährleistet eine kräftefreie Einführung des jeweiligen Fixierelements ohne ein Auslenken beispielsweise eines am Fixierelement befindlichen Rasthakens als Rastmittel notwendig zu machen. Eine zum Fixierelement leicht versetzte Anordnung der Fangbohrung ist ebenfalls eine mögliche Ausgestaltung um die Bestückung der Leiterplatte mit dem Bauelement kräftefrei zu gestalten. Die Forderung von Fangbohrungen mit einem genügend großen Durchmesser zur Aufnahme von beispielsweise jeweils einem Rasthaken ohne ein Verkanten oder dem Ausüben von Scherkräften ermöglicht eine Positionierung der Bauelementen auf der Leiterplatte mit linearen Bewegungsabläufen bezüglich der Bewegungsrichtung ohne jeglicher Verkippung der Bauteile zueinander. Das begünstigt den Einsatz beispielsweise eines Pick-and-Place-Roboters und somit eine Automatisierung in der Leiterplattenbestückung. In der beschriebenen Anordnung liegt die Positioniervorrichtung mit mindestens einer Stütze lösbar auf der Leiterplatte auf. Die Position der Positioniervorrichtung wird somit durch die Auflage auf der Leiterplatte gehalten, womit ein in das Halteelement der Positioniervorrichtung eingreifendes und/oder um das Halteelement umgreifendes Bauteil eines Bauelements, also entweder ein Kontaktelement oder ein Abstützelement, mittels einer in Lotrichtung zur Oberfläche der Leiterplatte wirkende Kraft nicht mehr ausgelenkt und/oder verschoben werden kann. Darüber hinaus kann bei einer Positionierung des Bauelements an der Kante der Leiterplatte das Bauelement gegen die Nachbarleiterplatte abgestützt und in korrekter Lötposition gehalten werden. Die Verfüllung des von dem Schaft des mindestens einen Fixierelements und dem Umfang der mindestens einen Fangbohrung der Leiterplatte begrenzten Raumes mit einem thermoplastischen, elektrisch leitfähigen lösbaren Material (Lot) erfolgt formschlüssig. Durch die metallbeschichteten Innenseiten der Fangbohrungen zieht sich beispielsweise bei einem Reflow-Lötprozess das Lot durch die Kapillarwirkung in die Fangbohrung und umschließt auf diese Weise den Schaft des Fixierelements. Es entsteht eine formschlüssige Fixierung vergleichbar mit dem Einrasten eines Rasthakens in die Leiterplatte, so dass nach dem Lötprozess die mechanische Fixierung des Bauelements sichergestellt bleibt. Gleiches gilt bei der Verwendung beispielsweise einer Einschnürung oder einer Öse, bei der das Lot durch die Öffnung der Öse hindurch das Fixierelement festhält. Es ist hierzu nicht erforderlich, dass das Fixierelement in dem Bereich, in dem das Lot die Fangbohrung verschließt metallisch ist. Bevorzugt ist das Fixierelement aus Kunststoff. Nach dem Erstarren des Lötmaterials wird die steckbare Befestigung des mindestens einen Halteelements der Positioniervorrichtung zu dem mindestens einen Kontaktelements oder dem Abstützelement von dem Bauelement gelöst. Durch das vollständige Verlöten des Bauelements, sowohl am Fixierelement als auch an den elektrischen Anschlusselementen, und dem Aushärten des Lots entsteht gegenüber herkömmlich verlöteten elektrischen Einheiten mit ungünstigem Schwerpunkt speziell an den Rastmittel eine zusätzliche Verankerung, um eine hohe mechanische Stabilität zu erhalten. Bei Bauteilen, bei denen der Schwerpunkt des Bauteils auch ohne Positioniervorrichtung eine stabile Lötposition während des Prozesses ermöglicht, jedoch eine mechanische Fixierung des Bauelements an der Leiterplatte erforderlich ist, sieht das Verfahren zur Lötbefestigung eines Bauelements mit mindestens einem Fixierelement, das einen Schaft mit mindestens einem in axialer Richtung wirkenden Rastmittel aufweist, folgende Schritte vor:
- Vorsehen einer Leiterplatte mit Kontaktbohrungen und mindestens einer Fangbohrung, wobei die mindestens eine Fangbohrung mindestens einen Durchmesser aufweist, welcher größer ist als der Querschnitt des Fixierelements, sodass das Fixierelement kräftefrei in die Fangbohrung eingesteckt werden kann;
- Anordnen des Bauelements auf der Leiterplatte mit den elektrischen Anschlusselementen in den Kontaktbohrungen und dem mindestens einen Rastmittel des Fixierelements des Bauelements kräftefrei in der mindestens einen Fangbohrung der Leiterplatte, so dass das Rastmittel des Fixierelements in der Fangbohrung oder durch die Fangbohrung hindurch positioniert wird;
- Verfüllen der mindestens einen Kontaktbohrung und der mindestens einen Fangbohrung mit einem flüssigen Lötmaterial und Erstarren des Lötmaterials; oder
- Aufschmelzen und Erstarren eines bereits in der mindestens einen Kontaktbohrung und der mindestens einen Fangbohrung befindlichen Lötmaterials.

Die Positionierung des Rastmittels des Fixierelements in der Fangbohrung hängt davon ab, wie das Rastmittel ausgestaltet ist. Im Falle beispielsweise eines Rasthakens wird dieser vollständig durch die Fangbohrung hindurchgeführt, während im Falle einer Einschnürung oder beispielsweise im Falle einer Öse das Rastmittel soweit in die Fangbohrung eingeführt wird, dass das Lot in die Einschnürung bzw. in die Öffnung der Öse gelangt. Entsprechend verhält es sich auch beispielsweise bei einem Gewinde oder einer anderen technisch geeigneten Ausgestaltung, die einen axialen Widerstand bildet. Die Bedeutung dieser Ausgestaltung der Erfindung ist vorstehend schon im Zusammenhang mit anderen Kombinationen erläutert.

Vorzugsweise kann das beschriebene Verfahren noch mit dem Anordnen einer Positionierungseinrichtung und/oder Abstützelementen sofern dies benötigt wird, kombiniert werden. Die einzelnen Schritte sind vorstehend in anderem Zusammenhang bereits beschrieben.

Durch die vorliegende Erfindung wird es ermöglicht, Bauelemente mit unterschiedlichen Ausformungen mit linearen Bewegungsabläufen auf einer Leiterplatte zu Positionieren und in der korrekten Ausrichtung für den Lötprozess zu halten. Die Bestückung erfolgt kräftefrei und begünstigt somit die Automatisierung und den Einsatz von beispielsweise Pick-and-Place-Robotern, welche das jeweilige Bauelement über die damit in Verbindung, entweder an einem Kontaktelement oder an einem Abstützelement ein- und/oder umgreifend, befindliche Positioniervorrichtung angreifen und bewegen. Die Stütze der Positioniervorrichtung ermöglicht einen sicheren Stand während des Lötprozesses, wie zum Beispiel im Reflow- als auch im Wellenlöt-Prozess. Es ist auch möglich, mit Leitkleber zu arbeiten. Nach Erstarren der Lötstellen kann die Positioniervorrichtung aufgrund der lösbaren Verbindung, sowie für den elektronischen Betrieb nichtfunktionelle Teile der Bauelemente, wie dem Abstützelement, leicht entfernt werden.

Die Erfindung ist anhand von in den Abbildungen dargestellten Ausführungsbeispielen näher erläutert. Weitere Merkmale ergeben sich aus der folgenden Beschreibung der Ausführungsbeispiele der Erfindung in Verbindung mit den Ansprüchen und den beigefügten Abbildungen. Die einzelnen Merkmale der Erfindung können für sich allein oder zu mehreren bei unterschiedlichen Ausführungsformen der Erfindung verwirklicht sein. Es zeigen
- Figur 1: eine schematische Darstellung eines Bauelements, einer Positioniervorrichtung und einer Leiterplatte vor der Montage;
- Figur 2: eine schematische Darstellung des Bauelements, der Positioniervorrichtung und der Leiterplatte im montierten Zustand auf der Leiterplatte;
- Figur 3: eine schematische Darstellung einer bevorzugten Ausformung des Bauelements mit Abstützelement, der Positioniervorrichtung und der Leiterplatte sowie deren Anordnung vor der Montage (Figur 3 (a)) und im montierten Zustand (Figur 3 (b));
- Figur 4: die einzelnen Verfahrensschritte zur Lötbefestigung des Fixierelements an der Leiterplatte

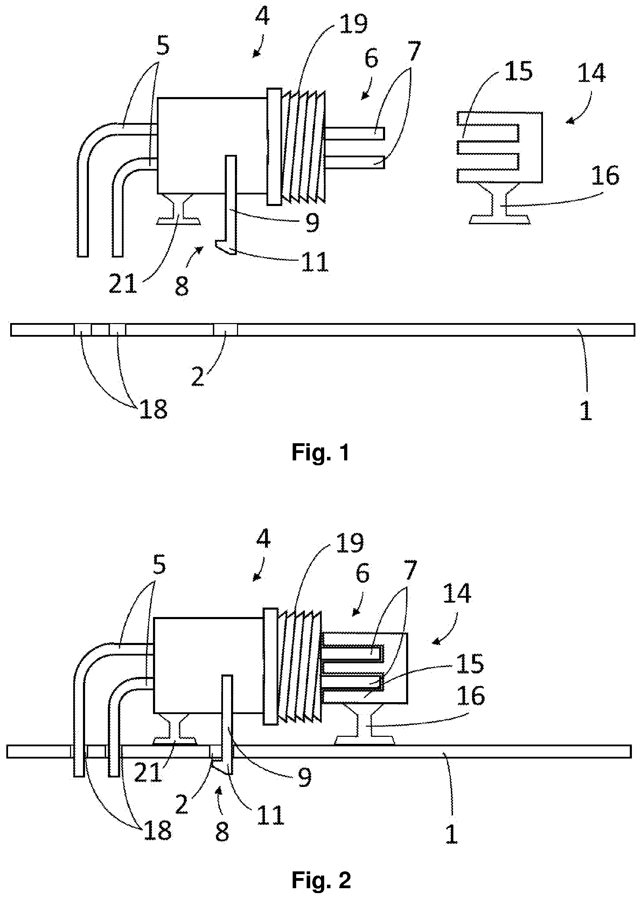

Das in Figur 1 dargestellte Ausführungsbeispiel zeigt den schematischen Aufbau in einer Seitenansicht der Bauteile, bestehend aus einer Leiterplatte 1, einem Bauelement 4 und einer Positioniervorrichtung 14. Die Leiterplatte 1 verfügt über mehrere Bohrungen 2,18, welche zueinander so ausgerichtet sind, dass sie alle zu verlötenden Anschlusselemente 5 und alle Fixierelemente 8 eines Bauelements 4 zeitgleich aufnehmen können. Üblicherweise ist in der Nähe der Anschlusselemente 5 mindestens eine Bauteilabstützung 21 vorgesehen. Die Bohrungen 2,18 weisen je nach Aufnahmezweck verschiedene Durchmesser auf, wodurch sich die hier dargestellten Fangbohrungen 2, zur Aufnahme des Fixierelements 8, gegenüber den Kontaktbohrungen 18, zur Aufnahme der Anschlusselemente 5, durch einen vergrößerten Durchmesser auszeichnen. Das Bauelement 4 umfasst die Anordnung aus elektrischen Anschlusselementen 5, dem mindestens einen Fixierelement 8, wobei dieses einen Schaft 9 und einen an den Schaft 9 anschließenden Rasthaken 11 aufweist, beispielsweise einem Schraubgewinde 19 zur Aufnahme eines hier nicht dargestellten Gerätesteckverbinders und ein elektrisches Kontaktelement 6 mit elektrischen Kontakten 7. In dieser schematischen Darstellung ist das Kontaktelement 6 durch die gezeigte Anordnung der elektrischen Kontakte 7 als zweipoliger Stecker ausgebildet. Die Positioniervorrichtung 14 umfasst eine Stütze 16, mit der die Positioniervorrichtung 14 auf der Leiterplatte 1 standfest aufgesetzt werden kann, sowie ein Halteelement 15, das komplementär zur zweipoligen Steckeranordnung des elektrischen Kontaktelements 6 ausgebildet ist.

Die Figur 2 zeigt eine schematische Darstellung der zweckmäßigen Anordnung der in Figur 1 vorgestellten Bauteile. Das Bauelement 4 ist derart zur Leiterplatte 1 ausgerichtet, dass seine Längserstreckung parallel zur Oberfläche der Leiterplatte 1 verläuft und zeitgleich einerseits die elektrischen Anschlusselemente 5 in den Kontaktbohrungen 18 und andererseits das Fixierelement 8 in der Fangbohrung 2 aufgenommen werden. Das Fixierelement 8 wird soweit durch die Fangbohrung 2 geführt, dass sich der Rasthaken 11 vorzugsweise vollständig unterhalb der dem Bauelement 4 abgewandten Oberfläche der Leiterplatte 1 befindet und der Schaft 9 von der Fangbohrung 2 umschlossen wird. Die Positioniervorrichtung 14 sitzt über die Stütze 16 auf der Leiterplatte 1 standfest auf und umgreift über das Halteelement 15 komplementär die elektrischen Kontakte 7 des Kontaktelements 6 des Bauelements 4.

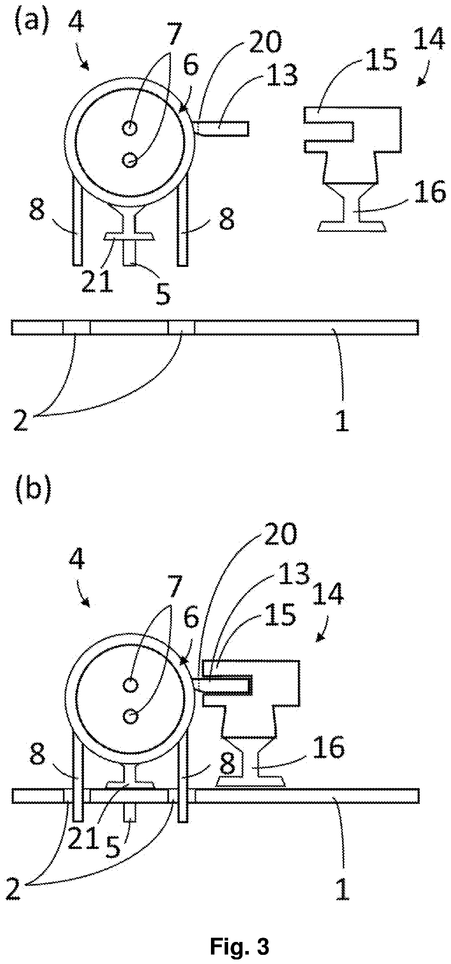

Analog zu den Figuren 1 und 2 zeigt Figur 3 eine weitere beispielhafte Ausführungsform in Form einer schematischen Darstellung in einer Frontansicht der erfindungsgemäß beteiligten Teile des Bauelements 4 (Figur 3 (a)) und deren Anordnung (Figur 3 (b)). In dieser Ausführung ist an dem Bauelement 4 ein Abstützelement 13 ausgebildet, welcher über eine Sollbruchfalz 20 lösbar mit dem Bauelement 4 verbunden ist. Die Positioniervorrichtung 14 sitzt in der Anordnung in Figur 3 (b) über die Stütze 16 auf der Leiterplatte 1 standfest auf und umgreift über das Halteelement 15 komplementär das Abstützelement 13 des Bauelements 4, so dass das Bauelement 4 für den Lötprozess in der korrekten Lötposition stabil gehalten werden kann. Gemäß einer anderen beispielhaften nicht dargestellten Ausführungsform kann das Abstützelement 13 abgewinkelt sein und sich dadurch selbst ohne Positioniervorrichtung 14 auf der Leiterplatte 1 abstützen. Je nach Bedarf kann das jeweilige Abstützelement 13 nach Beendigung des Lötprozesses abgebrochen werden. Die Anzahl der Abstützelement 13, insbesondere der sich selbst abstützenden (nicht dargestellten) Abstützelemente 13 ist beliebig.

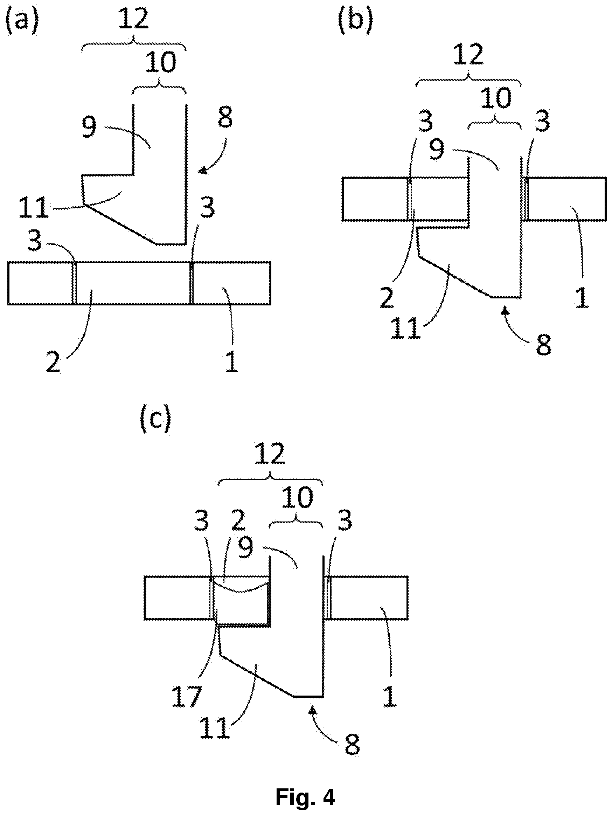

Figur 4 zeigt eine Detailansicht der in den Figuren 1-3 dargestellten Fixierelemente 8 und stellt in der Abfolge von Figur 4 (a) bis Figur 4 (c) die Verfahrensschritte zur Lötbefestigung des Fixierelements 8 an der Leiterplatte 1 dar. Zur Bestückung der Leiterplatte 1 wird das Bauelement 4 mit dem am Fixierelement 8 befindlichen Schaft 9 und dem am Schaft 9 anschließenden Rasthaken 11 durch die Fangbohrung 2 geführt. Der Durchmesser der Fangbohrung 2 ist so groß gewählt, dass der Rasthaken 11 mit dem Rastquerschnitt 12 von Figur 4 (a) nach Figur 4 (b) kräftefrei durch die Fangbohrung 2 geführt werden kann und direkt unterhalb der Leiterplatte 2 positioniert wird. Dadurch umschließt die Fangbohrung 2 in Figur 4 (b) den Schaft 9 mit einem Schaftquerschnitt 10 und bildet so einen Hohlraum, der durch die mit einer Metallbeschichtung 3 versehene Fangbohrung 2 und dem Schaft 9 begrenzt wird, welcher zusätzlich nach unten durch den Rasthaken 11 begrenzt wird. In Figur 4 (c) wird dieser Hohlraum durch Lötmaterial 17 verfüllt, derart dass das Lötmaterial 17 durch die metallbeschichteten Innenseiten 3 der Fangbohrung 2 durch beispielweise eine Kapillarwirkung in die Fangbohrung 2 gezogen wird und auf diese Weise den Schaft 9 des Fixierelements 8 umschließt.

## Patentansprüche

1. Verfahren zur Lötbefestigung eines Bauelements (4) mit elektrischen Anschlusselementen (5) zur Kontaktierung an einer Leiterplatte (1) und mindestens einem Fixierelement (8) zur mechanischen Fixierung des Bauelements (4) an der Leiterplatte (1), wobei das mindestens eine Fixierelement (8) einen Schaft (9) mit mindestens einem in axialer Richtung wirkenden Rastmittel (11) aufweist, wobei das Verfahren die folgenden Schritten umfasst:
- Vorsehen einer Leiterplatte (1) mit Kontaktbohrungen (18) und mit mindestens einer Fangbohrung (2), wobei die mindestens eine Fangbohrung (2) mindestens einen Durchmesser aufweist, welcher größer als der Querschnitt des Fixierelements (8) ist, so dass das Fixierelement (8) kräftefrei in die Fangbohrung (2) eingesteckt werden kann;
- Anordnen des Bauelements (4) auf der Leiterplatte (1) mit den elektrischen Anschlusselementen (5) in den Kontaktbohrungen (18) und dem mindestens einen Rastmittel (11) des Fixierelements (8) des Bauelements (4) kräftefrei in der mindestens einen Fangbohrung (2) der Leiterplatte (1), so dass das Rastmittel (11) des Fixierelements (8) in der Fangbohrung (2) oder durch die Fangbohrung (2) hindurch positioniert wird;
- Verfüllen der mindestens einen Kontaktbohrung (18) und der mindestens einen Fangbohrung (2) mit einem flüssigen Lötmaterial (17) und Erstarren des Lötmaterials (17) ; oder
- Aufschmelzen und Erstarren eines bereits in der mindestens einen Kontaktbohrung (18) und der mindestens einen Fangbohrung (2) befindlichen Lötmaterials (17);
wobei der vom Fixierelement (8) und dem Umfang der Fangbohrung (2) begrenzte Raum von dem Lötmaterial (17) formschlüssig verfüllt wird, nach Erstarren des Lötmaterials (17) eine Bewegung des Fixierelements (8) in axialer Richtung nicht mehr möglich ist, das Fixierelement (8) über das Lötmaterial (17) formschlüssig an der Leiterplatte (1) und dadurch das Bauelement (4) mechanisch an der Leiterplatte (4) fixiert ist.

2. Verfahren nach Anspruch 1, mit dem zusätzlichen Schritt des Anordnens mindestens einer Positioniervorrichtung (14) mit mindestens einem lösbar mit dem Bauelement (4) verbindbaren Halteelement (15) und mindestens einer Stütze (16) auf der Leiterplatte (1) oder einer benachbarten Leiterplatte, wobei die mindestens eine Positioniervorrichtung (14) über das Halteelement (15) das Bauelement (4) hält und sich mittels der Stütze (16) lösbar auf einer Leiterplatte (1) abgestützt wird, und mit dem zusätzlichen Schritt des Entfernens der Positioniervorrichtung (14) nach dem Erstarren des Lötmaterials (17).

3. Verfahren nach Anspruch 2, wobei das mindestens eine Halteelement (15) zumindest teilweise ein Kontaktelement (6) oder ein an dem Bauelement (4) befindliches Abstützelement (13) umgreift und/oder in das Kontaktelement (6) eingreift.

4. Verfahren nach Anspruch 1, mit dem zusätzlichen Schritt des Anordnens eines Bauelements (4) mit mindestens einem zusätzlichen Abstützelement (13) auf der Leiterplatte (1), wobei das Abstützelement das Bauelement (4) auf der Leiterplatte (1) oder einer benachbarten Leiterplatte abstützt.

5. Verfahren nach Anspruch 4, wobei das mindestens eine Abstützelement (13) nach dem Erstarren des Lötmaterials (17) entfernt wird.

## Claims

1. Method for fastening by soldering a component (4) with electrical connection elements (5) for making contact with a printed circuit board (1) and at least one fixing element (8) for mechanically fixing the component (4) to the printed circuit board (1), wherein the at least one fixing element (8) has a shaft (9) having at least one latching means (11) which acts in the axial direction, wherein the method comprises the following steps:
- providing a printed circuit board (1) having contact bores (18) and at least one capturing bore (2), wherein the at least one capturing bore (2) at least has a diameter which is larger than the cross section of the fixing element (8), so that the fixing element (8) can be inserted into the capturing bore (2) without force;
- arranging the component (4) on the printed circuit board (1) with the electrical connection elements (5) in the contact bores (18) and the at least one latching means (11) of the fixing element (8) of the component (4) in the at least one capturing bore (2) of the printed circuit board (1) without force, so that the latching means (11) of the fixing element (8) is positioned in the capturing bore (2) or through the capturing bore (2);
- filling the at least one contact bore (18) and the at least one capturing bore (2) with a liquid soldering material (17) and solidifying the soldering material (17); or
- melting and solidifying a soldering material (17) which is already located in the at least one contact bore (18) and the at least one capturing bore (2) ;
wherein the space delimited by the fixing element (8) and the circumference of the capturing bore (2) is filled in a form-fitting manner by the soldering material (17), any movement of the fixing element (8) in the axial direction no longer being possible after the soldering material (17) has solidified, the fixing element (8) being fixed in a form-fitting manner on the printed circuit board (1) by way of the soldering material (17) and the component (4) being mechanically fixed to the printed circuit board (1) as a result.

2. Method according to Claim 1, comprising the additional step of arranging at least one positioning device (14) having at least one holding element (15), which can be releasably connected to the component (4), and at least one support (16) on the printed circuit board (1) or an adjacent printed circuit board, wherein the at least one positioning device (14) holds the component (4) by way of the holding element (15) and is releasably supported on a printed circuit board (1) by means of the support (16), and comprising the additional step of removing the positioning device (14) after the soldering material (17) has solidified.

3. Method according to Claim 2, wherein the at least one holding element (15) at least partially encompasses a contact element (6) or a supporting element (13) located on the component (4) and/or engages in the contact element (6).

4. Method according to Claim 1, comprising the additional step of arranging a component (4) having at least one additional supporting element (13) on the printed circuit board (1), wherein the supporting element supports the component (4) on the printed circuit board (1) or an adjacent printed circuit board.

5. Method according to Claim 4, the at least one supporting element (13) is removed after the soldering material (17) has solidified.

## Revendications

1. Procédé permettant de fixer par brasage un composant (4) pourvu d'éléments de connexion électriques (5) pour la mise en contact sur une carte de circuits imprimés (1) et d'au moins un élément de fixation (8) pour la fixation mécanique du composant (4) sur la carte de circuits imprimés (1), dans lequel ledit au moins un élément de fixation (8) présente une tige (9) pourvue d'au moins un moyen d'arrêt (11) agissant dans une direction axiale, le procédé comprenant les étapes suivantes consistant à :
- prévoir une carte de circuits imprimés (1) pourvue de trous de contact (18) et d'au moins un trou de retenue (2), dans lequel ledit au moins un trou de retenue (2) présente au moins un diamètre qui est supérieur à la section transversale de l'élément de fixation (8) de sorte que l'élément de fixation (8) peut être inséré sans effort dans le trou de retenue (2) ;
- disposer le composant (4) sur la carte de circuits imprimés (1), avec les éléments de connexion électriques (5) dans les trous de contact (18) et ledit au moins un moyen d'arrêt (11) de l'élément de fixation (8) du composant (4), sans effort dans ledit au moins un trou de retenue (2) de la carte de circuits imprimés (1) de façon à positionner le moyen d'arrêt (11) de l'élément de fixation (8) dans le trou de retenue (2) ou à travers le trou de retenue (2) ;
- combler ledit au moins un trou de contact (18) et ledit au moins un trou de retenue (2) avec un matériau de brasage liquide (17) et laisser solidifier le matériau de brasage (17) ; ou
- faire fondre et solidifier un matériau de brasage (17) se trouvant déjà dans ledit au moins un trou de contact (18) et ledit au moins un trou de retenue (2) ;
dans lequel l'espace délimité par l'élément de fixation (8) et la circonférence du trou de retenue (2) est comblé par complémentarité de forme avec le matériau de brasage (17), après la solidification du matériau de brasage (17), aucun mouvement de l'élément de fixation (8) dans la direction axiale n'est plus possible, l'élément de fixation (8) est fixé à la carte de circuits imprimés (1) par l'intermédiaire du matériau de brasage (17) par complémentarité de forme, et le composant (4) est ainsi fixé mécaniquement à la carte de circuits imprimés (4).

2. Procédé selon la revendication 1, comprenant l'étape supplémentaire consistant à disposer au moins un dispositif de positionnement (14) pourvu d'au moins un élément de maintien (15) pouvant être relié de manière amovible au composant (4) et d'au moins un support (16) sur la carte de circuits imprimés (1) ou une carte de circuits imprimés voisine, dans lequel ledit au moins un dispositif de positionnement (14) maintient le composant (4) par l'intermédiaire de l'élément de maintien (15) et prend appui au moyen du support (16) de manière amovible sur une carte de circuits imprimés (1), et comprenant l'étape supplémentaire consistant à retirer le dispositif de positionnement (14) après la solidification du matériau de brasage (17).

3. Procédé selon la revendication 2, dans lequel ledit au moins un élément de maintien (15) entoure au moins partiellement un élément de contact (6) ou un élément de support (13) se trouvant au niveau du composant (4), et/ou vient en prise avec l'élément de contact (6).

4. Procédé selon la revendication 1, comprenant l'étape supplémentaire consistant à disposer un composant (4) pourvu d'au moins un élément de support supplémentaire (13) sur la carte de circuits imprimés (1), dans lequel l'élément de support supporte le composant (4) sur la carte de circuits imprimés (1) ou une carte de circuits imprimés voisine.

5. Procédé selon la revendication 4, dans lequel ledit au moins un élément de support (13) est retiré après la solidification du matériau de brasage (17).
